(19) Europäisches Patentamt
European Patent Office
Office européen des brevets

(11) **EP 3 062 236 A1**

(12) **EUROPEAN PATENT APPLICATION**

(43) Date of publication:
**31.08.2016 Bulletin 2016/35**

(51) Int Cl.:
***G06F 17/18*** (2006.01)

(21) Application number: **16156808.4**

(22) Date of filing: **23.02.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **24.02.2015 US 201514629549**

(71) Applicant: **Analog Devices, Inc.**
**Norwood, MA 02062-9106 (US)**

(72) Inventors:
• **Lerner, Boris**
  **Sharon, MA 02067 (US)**
• **Karanam, Gopal Gudhdur**
  **560098 Bangalore (IN)**

(74) Representative: **Thompson, Andrew John**
**Withers & Rogers LLP**
**4 More London Riverside**
**London SE1 2AU (GB)**

(54) **DOWNSAMPLING BY AVERAGING WITH REDUCED MEMORY REQUIREMENTS**

(57)    A method for downsampling digital samples $x_n, ...$ of a signal by a decimation factor d comprising an integer part i using averaging is disclosed. The method includes identifying a partial sum based on the decimation factor and a number N of samples to use for the averaging as a sum $S_{n,i,n,N-1}$ of (N-i) samples $x_{n+i}, ... x_{n+N-1}$, computing the partial sum, computing a first sum $S_{n,n+N-1}$ of a first set of N digital samples $x_n, ... x_{n+N-1}$ as a sum of a set of i digital samples $x_n, ... x_{n+i-1}$ and the computed partial sum, computing a second sum $S_{n+i,n+i+N-1}$ of a second set of N digital samples $x_{n+i}, ... x_{n+i+N-1}$ as a sum of a set of i digital samples $x_{n+N}, ... x_{n+;+N-1}$ and the computed partial sum, and downsampling the digital samples based at least in part on the first sum and the second sum.

FIGURE 3

**Description**

TECHNICAL FIELD OF THE DISCLOSURE

The present invention relates to the field of digital signal processing, in particular to systems and methods for computationally downsampling digital samples of a signal using an averaging filter.

BACKGROUND

Analog audio or image signals are converted to digital form by "sampling," i.e., repeatedly measuring the signal amplitude over time or over the image; the set of samples thus obtained constitutes a digital approximation of the initial signal and can be used to reproduce the signal. Decimation, also referred to as "downsampling," is an operation in digital-signal or-image processing in which a set of samples is reduced in size. For example, a set of 100 samples may be decimated by a factor of two by selecting 50 samples that best represent the analog signal defined by the original 100 samples. The selection may be made by simply selecting every odd (or even) sample or, in more sophisticated operations, by replacing every pair of original samples with their average.

Because decimation reduces the effective sampling rate of the signal, care must be taken that the new sampling rate is at least twice the frequency of any components within the original signal (the so-called Nyquist frequency). If the original signal included components with frequencies above the Nyquist frequency, they will be "aliased" and corrupt the components of interest in the sample set. An anti-aliasing filter may be used to remove these high-frequency components; in decimation operations, an averaging filter is commonly used as an anti-aliasing filter.

What is needed in the art is an approach to computationally downsampling digital samples of a signal using an averaging filter that minimized the amount of memory required.

OVERVIEW

In general, various aspects of the systems and methods described herein reduce the amount of required memory required for downsampling a stream of digital samples. History information about prior input samples is required to compute later output points, but the present invention saves as few as one carefully selected input data point and one partial sum of prior input samples (instead of an entire history of prior input samples). Using only this reduced set of history information, the present invention computes values for downsampled output data in accordance with a selected decimation rate and filter size.

One aspect of the present invention provides a computer-implemented method for a processor to computationally downsample digital samples $x_n$, $x_{n+1}$, ... of a signal by a decimation factor d using averaging. The decimation factor may be any real number comprising an integer part i and a fractional part f, so that d=i+f. The method includes a step of identifying a partial sum to use for the downsampling based on the decimation factor d and a number N of taps of an averaging filter as a sum $S_{n+i,n+N-1}$ of (N-i) samples $x_{n+i}$, ... $x_{n+N-1}$. The method further includes computing the partial sum $S_{n+i,n+N-1}$, preferably storing the computed partial sum $S_{n+i,n+N-1}$ in a hardware register, computing a first sum $S_{n,n+N-1}$ of a first set of N digital samples $x_n$, ... $x_{n+N-1}$ as a sum of a set of i digital samples $x_n$, ... $x_{n+i-1}$ and the computed partial sum $S_{n+i,n+N-1}$, computing a second sum $S_{n+i,n+i+N-1}$ of a second set of N digital samples $x_{n+i}$, ... $x_{n+i+N-1}$ as a sum of a set of i digital samples $x_{n+N}$, ... $x_{n+i+N-1}$ and the computed partial sum $S_{n+i,n+N-1}$, and downsampling the digital samples based at least in part on the first sum $S_{n,n+N-1}$ and the second sum $S_{n+i,n+i+N-1}$.

In various embodiments, the digital samples may correspond to a one- or two-dimensional signal, the two-dimensional signal may correspond to raster-scan image data, and partial sums may be stored corresponding to a row of input data.

Other aspects of the present invention relate to systems for carrying out methods described herein.

Moreover, a computer program for carrying out the methods described herein, as well as a, preferably non-transitory, computer readable storage-medium storing the computer program are provided. A computer program may, for example, be downloaded (updated) to the existing systems configured to do decimation (e.g. to the existing averaging filters or various digital processing circuits) or be stored upon manufacturing of these systems.

Since embodiments described herein are for performing downsampling/decimation, a functional component performing embodiments of the method described herein will be referred to in the following as a "decimation module." As will be appreciated by one skilled in the art, aspects of the present invention, in particular the functionality of the decimation module described herein, may be embodied as a system, a method or a computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system."

BRIEF DESCRIPTION OF THE DRAWINGS

To provide a more complete understanding of the present disclosure and features and advantages thereof, reference is made to the following description, taken in conjunction with the accompanying figures, wherein like reference numerals represent like parts, in which:

FIGURE 1A schematically illustrates a flowchart for downsampling a stream of digital data, according to one embodiment of the present invention;
FIGURE 1B schematically illustrates a flowchart illustrating interpolation between sums in case of a non-integer decimation factor, according to one embodiment of the present invention;
FIGURE 2 provides a representation of downsampling a stream of digital data, according to one embodiment of the present invention;
FIGURE 3 provides another representation of downsampling a stream of digital data, according to one embodiment of the present invention;
FIGURE 4 provides an illustrative example of downsampling a stream of digital data, according to one embodiment of the present invention;
FIGURE 5 schematically illustrates a system for downsampling a stream of digital data, according to one embodiment of the present invention; and
FIGURE 6 schematically illustrates a computing system that could be configured to carry out the functionality of a decimation module, according to one embodiment of the present invention.

DESCRIPTION OF EXAMPLE EMBODIMENTS OF THE DISCLOSURE

Basics of an averaging filter

An averaging filter outputs a point *y* at a location n (i.e., the *nth* point *y*), given an input set of points x, by averaging *N* input points *x* for each output point *y*. This operation is expressed formally in Equation (1) below:

$$y_n = \frac{1}{N} \sum_{k=n}^{n+N-1} x_k \tag{1}$$

For example, if 10 input points *x* are averaged for each output point y (*N* = 10), then $y_0$ is the average of $x_0$ through $x_9$, $y_1$ is the average of $x_1$ through $x_{10}$, $y_2$ is the average of $x_2$ through $x_{11}$, and so on. The sum needed for each new average may be computed by taking the value of the sum in the last average, subtracting the value of the "oldest" sample, and adding the value of the "newest" sample. For example, to compute the average of $x_1$ through $x_{10}$, the value of $x_0$ is subtracted from the sum of $x_0$ through $x_9$ (which is already computed for the previous average), and the value of $x_{10}$ is added. More formally, the sum of input points *x* from $x_n$ to $x_m$ is given below in Equation (2):

$$S_{n,m} = \sum_{k=n}^{m} x_k \tag{2}$$

The value of a "next" sum is therefore defined by Equation (3) below

$$S_{(n+1),(m+1)} = S_{n,m} - x_n + x_{(m+1)} \tag{3}$$

in which the distance between *n* and *m* is defined by *N*, and thus *m* = *n* + (*N* - 1).
For the sake of illustration, Equation (3) becomes, using the example above, the expression shown below in Equation (4):

$$S_{1,10} = S_{0,9} - x_0 + x_{10} \tag{4}$$

In general, Equation (1) may be re-written as an average of computed sums, as shown below in Equation (5):

$$y_n = \frac{1}{N} S_{n,m} \tag{5}$$

While this approach is attractive because it requires only one additional addition and subtraction operation per sample, it requires that the $N - 1$ previous samples be stored in memory (because, at each new sample, the process must know the value of the "oldest" sample in order to subtract it). This memory requirement becomes even more severe in the case of operations such as raster-order image streaming, which requires the storage of $N - 1$ previous lines of samples. The memory required for such storage may exceed the local storage space available to a processor, requiring the use of slower, system memory. In the worst case, the fetching and retrieval from system memory is too slow to keep up with the incoming data rate, and the filtering process fails. A need therefore exists for a decimation operation that has a lower memory requirement.

Downsampling with lower memory requirements

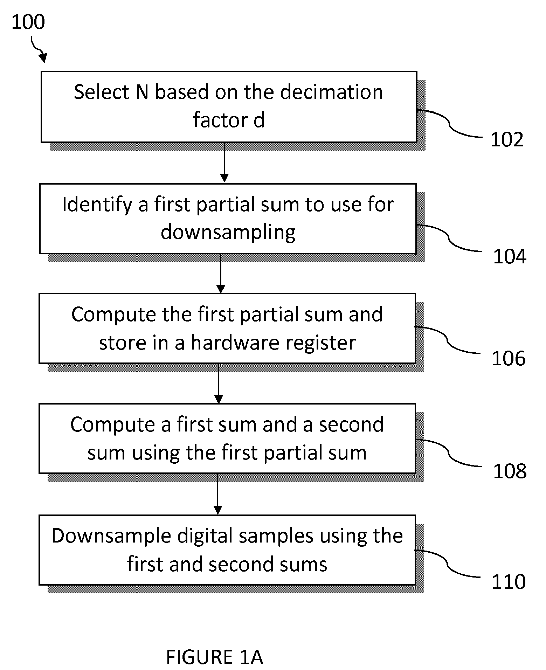

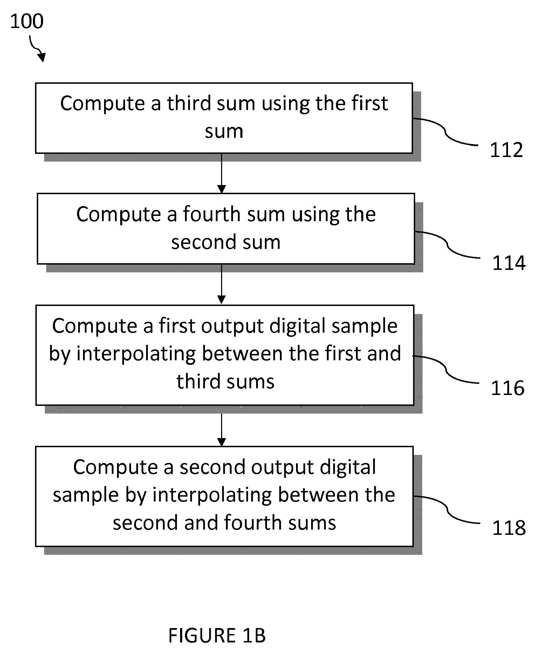

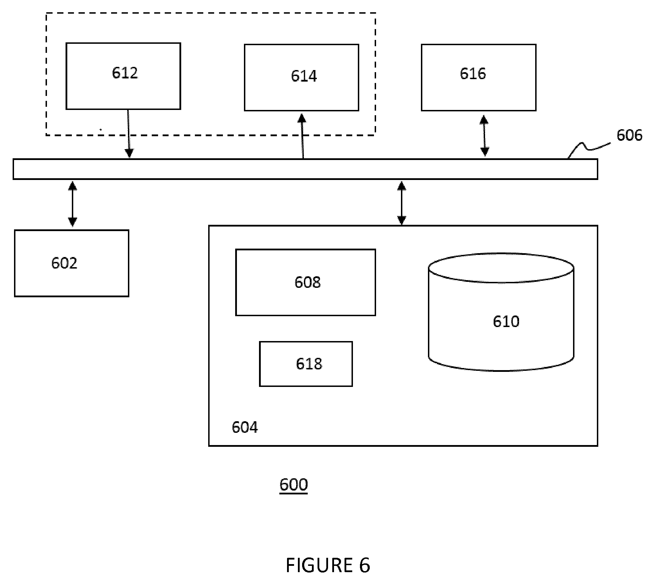

A method 100 for downsampling digital samples $x_n$, $x_{n+1}$, ... of a signal by a decimation factor d in accordance with embodiments of the present invention is shown in FIGURE 1A. The method 100 is described with reference to a decimation module such as e.g. a decimation module 600 shown in FIGURE 6. However, a person skilled in the art will recognize that any system performing, in any order, steps of the method illustrated in FIGUREs 1A and 1B is within the scope of the present invention.

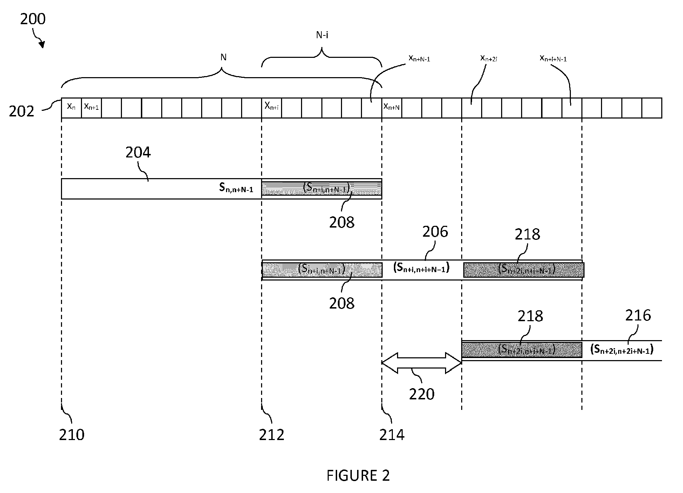

First, the method 100 is described in general terms, with reference to FIGUREs 1A and 1B, followed up by FIGURES 2-4 providing schematic illustrations of the method, in particular of the different sums mentioned in the method 100.

In general, the decimation factor d may be any real number comprising an integer part i and a fractional part f, so that d may be presented as:

$$d = i + f \tag{6}$$

In a first step 102, the decimation module 600 may be configured to determine a number N corresponding to the size (i.e., number of "taps") of an averaging filter to be used for the downsampling by selecting N to be an integer that is equal to or greater than d+2 and less than 2i. As becomes clear from the explanations below, selecting the number N in this manner allows implementing a downsampling method using averaging over N digital samples that takes advantage of the partial sum re-use described herein while avoiding the situation that the method fails because the partial sums start to overlap.

Once selected, the number of samples used to compute each sum (and later, to compute each average), N, may remain constant throughout the downsampling method 100. As one of skill in the art will understand, embodiments of the current invention are not limited to any particular filter size/tap number N, as long as N is selected as described in step 102.

In step 104, the decimation module 600 may identify a first partial sum $S_{n+i,n+N-1}$ to use for the downsampling as a sum of of (N-i) samples $x_{n+i}$, ... $x_{n+N-1}$:

$$S_{n+i,n+N-1} = \sum_{k=n+i}^{n+N-1} x_k \tag{7}$$

In step 106, the decimation module 600 computes the identified partial sum and, preferably but optionally, stores it in a local memory, e.g. in a hardware register.

In step 108, the decimation module 600 may compute two different sums based on the same first partial sum computed in step 104. Namely, the decimation module 600 computes a first sum $S_{n,n+N-1}$ of a first set of N digital samples $x_n$, ... $x_{n+N-1}$ and a second sum $S_{n+i,n+i+N-1}$ of a second set of N digital samples $x_{n+i}$, ... $x_{n+i+N-1}$.

Because of the appropriate selection of the number N as described above, the first and second sets of N digital samples "overlap" - that is, the first and second sets share some samples in common - and the partial sum of samples computed in step 106 corresponds to this overlapping section. Therefore, instead of saving the first set of N samples, computing the first sum as a sum of these N samples and then computing again a sum of some of those samples when computing the second sum, the method 100 accesses the partial sum computed and stored in step 106 and uses it to compute the first and second sums.

In particular, the decimation module 600 computes the first sum $S_{n,n+N-1}$ of the first set of N digital samples $x_n, ... x_{n+N-1}$ as a sum of a set of i digital samples $x_n, ... x_{n+i-1}$ and the computed partial sum $S_{n+i,n+N-1}$:

$$S_{n,n+N-1} = \sum_{k=n}^{n+i-1} x_k + S_{n+i,n+N-1} \qquad (8)$$

The decimation module 600 computes the second sum $S_{n+i,n+i+N-1}$ of the second set of N digital samples $x_{n+i}, ... x_{n+i+N-1}$ as a sum of a set of i digital samples $x_{n+N}, ... x_{n+i+N-1}$ and the computed partial sum $S_{n+i,n+N-1}$:

$$S_{n+i,n+i+N-1} = \sum_{k=n+N}^{n+i+N-1} x_k + S_{n+i,n+N-1} \qquad (9)$$

The computed first and second sums may be stored in a local memory, e.g. in a hardware register. Further information about the digital samples (i.e., their values) need not be saved or retained, thus reducing the memory requirements of the downsampling operation 100. In addition, computational resources of the decimation module 600 may be minimized by avoiding re-calculation of the partial sum $S_{n+i,n+N-1}$.

In step 110, the decimation module 600 downsamples the digital samples $x_n, x_{n+1}, ...$ of the signal using the computed first and second sums.

As explained in greater detail below, the first and second sums may be just two of a great many sums computed. The number of samples included in each sum, which samples are included in which sums, and the number of sums are all design parameters that depend on the decimation ratio, the filter size N, and/or other design parameters.

In case the decimation factor d comprises a non-zero fractional part f, downsampling of step 110 of FIGURE 110 may involve interpolation between sums, as described with the reference to FIGURE 1B. Thus, FIGURE 1B may be viewed as a more detailed illustration of step 110 of FIGURE 1A. With this in mind, in an embodiment of FIGURE 1B, the method 100 shown in FIGURE 1A may proceed from step 108 to step 112, where the decimation module 600 computes a first additional sum $S_{n+1,n+N}$ of a third set of N samples $x_{n+1}, ... x_{n+N}$ by subtracting $x_n$ from the first sum $S_{n,n+N-1}$ and by adding another digital sample $x_{n+N}$:

$$S_{n+1,n+N} = S_{n,n+N-1} - x_n + x_{n+N} \qquad (10)$$

In step 114 (which could also be performed before or simultaneously with step 112), the decimation module 600 computes a second additional sum $S_{n+i+1,n+i+N}$ of a fourth set of N samples $X_{n+i+1}, ... x_{n+i+N}$ by subtracting $x_{n+i}$ from the second sum $S_{n+i,n+i+N-1}$ and by adding another digital sample $x_{n+i+N}$:

$$S_{n+i+1,n+i+N} = S_{n+i,n+i+N-1} - x_{n+i} + x_{n+i+N} \qquad (11)$$

The decimation module 600 may compute a first output digital sample $y_n$ by interpolating between the first sum $S_{n,n+N-1}$ and the first additional sum $S_{n+i,n+N}$ (step 116), and compute a second output digital sample $y_{n+1}$ by interpolating between the second sum $S_{n+i,n+i+N-1}$ and the second additional sum $S_{n+i+1,n+i+N}$ (step 118).

In an embodiment, the interpolation may be carried out by computing weighted averages using weights dependent on the fractional part of the decimation factor.

In particular, the first output digital sample $y_n$ may be calculated as follows:

$$y_n = \frac{1}{N}\left(S_{n,n+N-1}\right) \qquad (12)$$

Continuing with this example of downsampling the digital samples $x_n, x_{n+1}, ...,$ the second output digital sample $y_{n+1}$ may be calculated as follows:

$$y_{n+1} = \frac{1}{N}((1-f) \times S_{n+i,n+i+N-1} + f \times S_{n+i+1,n+i+N}) \qquad (13)$$

In general, for an integer k being equal to or greater than zero and as long as $k \times f < 1$, a downsampled digital sample $y_{n+k}$ is calculated as follows:

$$y_{n+k} = \frac{1}{N}((1-k \times f) \times S_{n+k\times i,n+k\times i+N-1} + k \times f \times S_{n+k\times i+1,n+k\times i+N}) \qquad (14)$$

Equation (14) may be further generalized as follows:

$$y_{n+k} = \frac{1}{N}((1-frac(k \times d)) \times S_{n+\mathrm{int}(k\times d),n+\mathrm{int}(k\times d)+N-1} + frac(k \times d) \times S_{n+\mathrm{int}(k\times d)+1,n+\mathrm{int}(k\times d)+N}) \qquad (15),$$

where *"frac"* indicates a fractional part of a variable in the parenthesis and *"int"* indicates an integer part of a variable in the parenthesis.

A graphical representation 200 of one embodiment of the method 100 is shown in FIG. 2. An incoming stream of digital samples 202 begins with a first sample $x_n$ and includes, N samples later, a second sample $x_{n+N-1}$.

The first sum 204 of the first set of N samples $x_n \ldots x_{n+N-1}$ is $S_{n,n+N-1}$. The second sum 206 of a second set of N samples that overlaps the first sum 204 by N-i samples in an overlapping region 208. The beginning of the overlapping region is thus N-i samples less than the end $x_{n+N-1}$ of the first sum 204 and may be represented by $x_{n+i}$. The second sum 206 may thus be represented by $S_{n+i,n+i+N-1}$, and the partial sum of the overlapping region 208 is $S_{n+i,n+N-1}$.

At a first time 210, at the beginning of the digital samples 202, the samples 202 are being added to obtain the first sum 204 (and may be discarded after said addition). At a second, later time 212, the overlapping region 208 is reached. At this point, the partial sum 208 is computed and saved separately from the first sum 204. The entire first sum 204 may be saved or only the non-overlapping part of it (i.e., $S_{n,n+i-1}$) may be saved; the invention is not limited to any particular type of storage.

At a still later time 214, no further samples are required for the first sum 204. The partial sum 208 is added to the second sum 206, and additional samples 202 are added as necessary to the second sum 206. As FIGURE 2 illustrates, the N samples of the first sum 204 are not needed to compute the second sum 206; only the partial sum 208 need be stored. The process continues with a third sum $S_{n+2i,n+2i+N-1}$ 216 having an overlapping region $S_{n+2i,n+i+N-1}$ 218, and additional sums and additional overlapping regions are computed in a similar manner.

The three sums 204, 206, 216 may be used to compute three output points $y_1$, $y_2$, $y_3$ by dividing each of the sums 204, 206, 216 by N. In this very simple example, the decimation factor is given by the frequency of the computation of the sums; if, for example, a new sum is computed for every ten input samples, the decimation factor is ten.

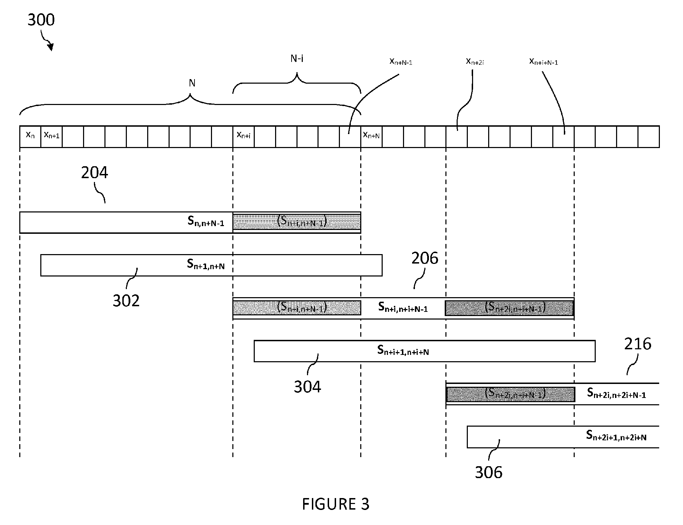

A more sophisticated decimation scheme 300 is depicted in FIGURE 3. In addition to the first 204, second 206, and third 216 sums described above with reference to FIGURE 2, the scheme 300 takes additional sums 302, 304, and 306. Each pair of sums, i.e. the first sum 204 and the first additional sum 302, the second sum 206 and the second additional sum 304, and the third sum 216 and the third additional sum 206, is bilinerally interpolated to produce each output point $y_1$, $y_2$, $y_3$.

Each additional sum 302, 304, 306 has the same number of samples (i.e., N) as the first 204, second 206, and third 216 sums, but is shifted by one sample (i.e., the first additional sum 302 is $S_{n+1,n+N}$, the second additional sum 304 is $S_{n,i+1,n+i+N}$, and the third additional sum 306 is $S_{n+2i+1,n+2i+N}$). Each additional sum 302, 304, 306 may therefore be derived from the first 204, second 206, and third 216 sums by subtracting out the first sample (e.g., $x_n$) and adding in the next sample (e.g., $x_{n+N}$). This first sample may be stored for each additional sum 302, 304, 306 (along with the partial sums 208, 218) so that it is available.

If a decimation scheme requires higher-order (e.g., third-order) interpolation, additional sums may be taken and additional input data samples may be stored to compute those sums. For example, the above method describes interpolating between two sums, $S_{n,n+N-1}$ and $S_{n+1,n+N}$, which in one embodiment stores the input sample $x_n$. If a third-order interpolation is desired, a third sum $S_{n+2,n+N+1}$, may be computed by additionally storing $x_{n+1}$. Similarly, if bilinear interpolation is used, but the additional sum is shifted by two or more samples, additional samples may be stored to compute the second sum. For example, if the first sum is $S_{n,n+N-1}$ and the second sum is $S_{n+2,n+N+1}$, either both $x_n$ and $x_{n+1}$ or their sum may be stored.

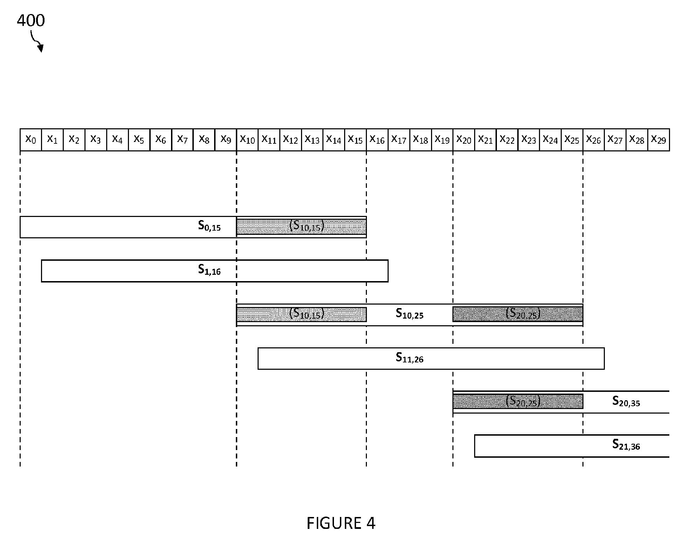

An illustrative example 400 of one embodiment of the invention is shown in FIGURE 4. In this example, the averaging filter has sixteen taps, so N = 16. The decimation factor is 10.3, meaning that for every 103 input samples x, 10 output samples y are produced. The method uses bilinear interpolation of sums produced by the averaging filter to calculate the output samples y. For example, filter outputs $y_0$ and $y_1$ are interpolated to make a first final output point, $y_{10}$ and $y_{11}$ are interpolated to make a second, $y_{20}$ and $y_{21}$ a third, $y_{30}$ and $y_{31}$ a fourth, and $y_{41}$ and $y_{42}$ a fifth. Note that the coordinates of the fifth output point (41 and 42) are shifted by one, with respect to the trend in the rest of the output points (0, 10, 20, 30, etc.) to account for the ".3" part of the "10.3" decimation factor.

Each output y of the averaging filter is based on an average of sixteen input points (because N = 16). The filter outputs $y_0$, $y_{10}$, $y_{20}$, $y_{30}$, and $y_{41}$ are given below by Equations (16)-(20).

$$y_0 = \frac{1}{N} S_{0,15} \qquad (16)$$

$$y_{10} = \frac{1}{N} S_{10,25} \qquad (17)$$

$$y_{20} = \frac{1}{N} S_{20,35} \qquad (18)$$

$$y_{30} = \frac{1}{N} S_{30,45} \qquad (19)$$

$$y_{41} = \frac{1}{N} S_{41,56} \qquad (20)$$

The sums appearing in Equations (16)-(20) may be computed in accordance with Equations (21)-(25), which highlight the partial sums re-used in each sum. For example, the partial sum $S_{10,15}$ appears in Equations (21) and (22), the partial sum $S_{20,25}$ appears in Equations (22) and (23), the partial sum $S_{30,35}$ appears in Equations (23) and (24), and the partial sum $S_{41,45}$ appears in Equations (24) and (25):

$$S_{0,15} = S_{0,9} + S_{10,15} \qquad (21)$$

$$S_{10,25} = S_{10,15} + S_{16,19} + S_{20,25} \qquad (22)$$

$$S_{20,35} = S_{20,25} + S_{26,29} + S_{30,35} \qquad (23)$$

$$S_{30,45} = S_{30,35} + S_{36,40} + S_{41,45} \qquad (24)$$

$$S_{41,56} = S_{41,45} + S_{46,50} + S_{51,56} \qquad (25)$$

As described above, the rest of the sums $S_{1,16}$, $S_{11,26}$, $S_{21,36}$, $S_{31,46}$, and $S_{42,57}$ may be computed by subtracting out the "oldest" sample from the corresponding above sums and adding in the next sample, as given below in Equations (26)-(30):

$$S_{1,16} = S_{0,15} - x_0 + x_{16} \qquad (26)$$

$$S_{11,26} = S_{10,25} - x_{10} + x_{26} \qquad (27)$$

$$S_{21,36} = S_{20,35} - x_{20} + x_{36} \qquad (28)$$

$$S_{31,46} = S_{30,45} - x_{30} + x_{46} \qquad (29)$$

$$S_{42,57} = S_{41,56} - x_{41} + x_{57} \qquad (30)$$

Thus, for each new sum, only the previous partial sum (e.g., $S_{1,16}$, $S_{11,26}$, $S_{21,36}$, $S_{31,46}$, and $S_{42,57}$) and the previous "oldest" sample (e.g., $X_0$, $X_{10}$, $X_{20}$, $X_{30}$, and $X_{41}$) is stored.

The above discussion contemplates a one-dimensional stream of input data samples, such as samples corresponding to an audio signal. The digital samples may, however, correspond to a two-dimensional digital image or video stream (received in, for example, raster order). In this case, instead of saving a single partial sum, a number of partial sums corresponding to one line of the image/video is stored. While, for a single dimension, memory savings due to the implementation of the methods described herein may amount to saving the length of an averaging filter (i.e. N) buffer, which is typically less than 100, for two-dimensional data, to filter e.g. in the vertical direction, memory savings may amount to saving N full horizontal lines. For high definition (HD) data this may amount to N*1920 - a very significant saving. Furthermore, by using the methods described herein in three-dimensional filtering, saving of N frames of data for HD data could amount to N*1920*1080, which is enormous.

In addition, instead of storing a single "oldest" point, a number of points corresponding to an oldest line of the image/video is stored.

As one of skill in the art will understand, embodiments of the current invention may be applied to input data having higher-order dimensions (e.g., third dimension or greater); in each case, the intermediate-sum storage has a dimension one less than that of the input data. For example, one-dimensional input data may use an intermediate sample, two-dimensional input data uses an intermediate one-dimensional array of values, three-dimensional input data uses an intermediate two-dimensional array, and so on.

As previously described herein, the number N is selected to comply with the desired decimation factor. If, for example, the number of taps N increases to approximately two times the decimation factor, the partial sums may overlap/intersect. With reference to FIGURE 2, this effect occurs when the distance 220 falls to zero. As one of skill in the art will realize, however, increasing N to this point may be unnecessary because the minimum size of N (as required by the Nyquist frequency) is less than two times the decimation factor.

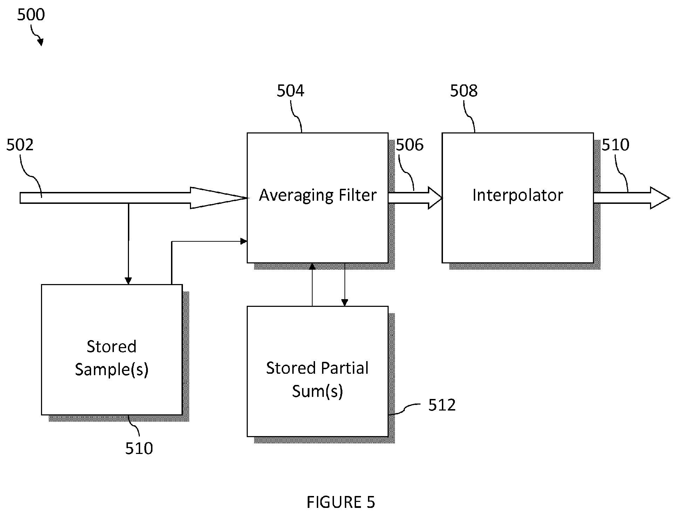

One system 500 for downsampling signals is shown in FIGURE 5. An incoming stream of data 502, having a high sample rate, is received by an averaging filter 504. The filter 504 provides a series of averaged filter outputs 506 to an interpolator 508; the interpolator 508, in turn, interpolates between two or more filter outputs 506 to provide a final output 510. A first memory 512 stores one or more "oldest" sample points that may be used to compute sums derived from already-computed sums. A second memory 512 stores partial sums for use in computing sums of the input data 502. In various embodiments, the filter 504 and the interpolator 508 may be digital-logic devices implemented with, for example CMOS transistors, and may be custom-tailored devices, part of an ASIC design, or software modules implemented on a conventional processor (such as a digital-signal processor) programmed to carry out the operations described above. The memories 510, 512 may be any kind of volatile or non-volatile storage media, such as random-access memory, a register file, or custom registers. One of skill in the art will understand that the present invention is not limited to the particular combination of components in FIGURE 5, and that the components may be combined or further split apart without deviating from the intent of the invention. The memories 510, 512, for example, may be combined.

FIGURE 6 depicts a block diagram illustrating a decimation module 600 implemented as an exemplary data processing system.

As shown in FIGURE 6, the data processing system 600 may include at least one processor 602 coupled to memory elements 604 through a system bus 606. As such, the data processing system may store program code within memory elements 604. Further, the processor 602 may execute the program code accessed from the memory elements 604 via a system bus 606. In one aspect, the data processing system may be implemented as a computer that is suitable for storing and/or executing program code. It should be appreciated, however, that the data processing system 600 may be implemented in the form of any system including a processor and a memory that is capable of performing the functions described within this specification.

The memory elements 604 may include one or more physical memory devices such as, for example, local memory 608 and one or more bulk storage devices 610. The local memory may refer to random access memory or other non-persistent memory device(s) generally used during actual execution of the program code. A bulk storage device may be implemented as a hard drive or other persistent data storage device. The processing system 600 may also include one or more cache memories (not shown) that provide temporary storage of at least some program code in order to reduce the number of times program code must be retrieved from the bulk storage device 610 during execution.

Input/output (I/O) devices depicted as an input device 612 and an output device 614, optionally, can be coupled to the data processing system. Examples of input devices may include, but are not limited to, a keyboard, a pointing device such as a mouse, or the like. Examples of output devices may include, but are not limited to, a monitor or a display, speakers, or the like. Input and/or output devices may be coupled to the data processing system either directly or through intervening I/O controllers.

In an embodiment, the input and the output devices may be implemented as a combined input/output device (illustrated in FIGURE 6 with a dashed line surrounding the input device 612 and the output device 614). An example of such a combined device is a touch sensitive display, also sometimes referred to as a "touch screen display" or simply "touch screen". In such an embodiment, input to the device may be provided by a movement of a physical object, such as e.g. a stylus or a finger of a user, on or near the touch screen display.

A network adapter 616 may also be coupled to the data processing system to enable it to become coupled to other systems, computer systems, remote network devices, and/or remote storage devices through intervening private or public networks. The network adapter may comprise a data receiver for receiving data that is transmitted by said systems, devices and/or networks to the data processing system 600, and a data transmitter for transmitting data from the data processing system 600 to said systems, devices and/or networks. Modems, cable modems, and Ethernet cards are examples of different types of network adapter that may be used with the data processing system 600.

As pictured in FIGURE 6, the memory elements 604 may store an application 618. In various embodiments, the application 618 may be stored in the local memory 608, the one or more bulk storage devices 610, or apart from the local memory and the bulk storage devices. It should be appreciated that the data processing system 600 may further execute an operating system (not shown in FIGURE 6) that can facilitate execution of the application 618. The application 618, being implemented in the form of executable program code, can be executed by the data processing system 600, e.g., by the processor 602. Responsive to executing the application, the data processing system 600 may be configured to perform one or more operations or method steps described herein.

Variations and implementations

While embodiments of the present invention were described above with references to exemplary implementations as shown in FIGURES 5 and 6, a person skilled in the art will realize that the various teachings described above are applicable to a large variety of other implementations.

In certain contexts, the features discussed herein can be applicable to automotive systems, medical systems, scientific instrumentation, wireless and wired communications, radar, industrial process control, audio and video equipment, current sensing, instrumentation (which can be highly precise), and other digital-processing-based systems.

Moreover, certain embodiments discussed above can be provisioned in digital signal processing technologies for medical imaging, patient monitoring, medical instrumentation, and home healthcare. This could include pulmonary monitors, accelerometers, heart rate monitors, pacemakers, etc. Other applications can involve automotive technologies for safety systems (e.g., stability control systems, driver assistance systems, braking systems, infotainment and interior applications of any kind).

In yet other example scenarios, the teachings of the present disclosure can be applicable in the industrial markets that include process control systems that help drive productivity, energy efficiency, and reliability. In consumer applications, the teachings of the signal processing circuits discussed above can be used for image processing, auto focus, and image stabilization (e.g., for digital still cameras, camcorders, etc.). Other consumer applications can include audio and video processors for home theater systems, DVD recorders, and high-definition televisions.

In the discussions of the embodiments above, components of a system, such as e.g. clocks, multiplexers, buffers, and/or other components can readily be replaced, substituted, or otherwise modified in order to accommodate particular circuitry needs. Moreover, it should be noted that the use of complementary electronic devices, hardware, software, etc. offer an equally viable option for implementing the teachings of the present disclosure.

Parts of various systems for downsampling using averaging over N samples can include electronic circuitry to perform the functions described herein. In some cases, one or more parts of the system can be provided by a processor specially configured for carrying out the functions described herein. For instance, the processor may include one or more application specific components, or may include programmable logic gates which are configured to carry out the functions describe herein. The circuitry can operate in analog domain, digital domain, or in a mixed signal domain. In some instances, the processor may be configured to carrying out the functions described herein by executing one or more instructions stored on a non-transitory computer readable storage medium.

In one example embodiment, any number of electrical circuits of FIGURES 5 and 6 may be implemented on a board of an associated electronic device. The board can be a general circuit board that can hold various components of the internal electronic system of the electronic device and, further, provide connectors for other peripherals. More specifically, the board can provide the electrical connections by which the other components of the system can communicate electrically. Any suitable processors (inclusive of digital signal processors, microprocessors, supporting chipsets, etc.), computer-readable non-transitory memory elements, etc. can be suitably coupled to the board based on particular configuration needs, processing demands, computer designs, etc. Other components such as external storage, additional sensors, controllers for audio/video display, and peripheral devices may be attached to the board as plug-in cards, via cables, or integrated into the board itself. In various embodiments, the functionalities described herein may be implemented in emulation form as software or firmware running within one or more configurable (e.g., programmable) elements arranged in a structure that supports these functions. The software or firmware providing the emulation may be provided on non-transitory computer-readable storage medium comprising instructions to allow a processor to carry out those functionalities.

In another example embodiment, the electrical circuits of FIGURES 5 and 6 may be implemented as standalone modules (e.g., a device with associated components and circuitry configured to perform a specific application or function) or implemented as plug-in modules into application specific hardware of electronic devices. Note that particular embodiments of the present disclosure may be readily included in a system on chip (SOC) package, either in part, or in whole. An SOC represents an IC that integrates components of a computer or other electronic system into a single chip. It may contain digital, analog, mixed-signal, and often radio frequency functions: all of which may be provided on a single chip substrate. Other embodiments may include a multi-chip-module (MCM), with a plurality of separate ICs located within a single electronic package and configured to interact closely with each other through the electronic package. In various other embodiments, the functionalities of downsampling using averaging over N samples may be implemented in one or more silicon cores in Application Specific Integrated Circuits (ASICs), Field Programmable Gate Arrays (FPGAs), and other semiconductor chips.

It is also imperative to note that all of the specifications, dimensions, and relationships outlined herein (e.g., the number of processors, logic operations, etc.) have only been offered for purposes of example and teaching only. Such information may be varied considerably without departing from the spirit of the present disclosure, or the scope of the appended claims. The specifications apply only to one non-limiting example and, accordingly, they should be construed as such. In the foregoing description, example embodiments have been described with reference to particular processor and/or component arrangements. Various modifications and changes may be made to such embodiments without departing from the scope of the appended claims. The description and drawings are, accordingly, to be regarded in an illustrative rather than in a restrictive sense.

Note that with the numerous examples provided herein, interaction may be described in terms of two, three, four, or more electrical components. However, this has been done for purposes of clarity and example only. It should be appreciated that the system can be consolidated in any suitable manner. Along similar design alternatives, any of the illustrated components, modules, and elements of FIGURES 5 and 6 may be combined in various possible configurations, all of which are clearly within the broad scope of this Specification. In certain cases, it may be easier to describe one or more of the functionalities of a given set of flows by only referencing a limited number of electrical elements. It should be appreciated that the electrical circuits of FIGURES 5 and 6 and its teachings are readily scalable and can accommodate a large number of components, as well as more complicated/sophisticated arrangements and configurations. Accordingly, the examples provided should not limit the scope or inhibit the broad teachings of the electrical circuits as potentially applied to a myriad of other architectures.

Note that in this Specification, references to various features (e.g., elements, structures, modules, components, steps, operations, characteristics, etc.) included in "one embodiment", "example embodiment", "an embodiment", "another embodiment", "some embodiments", "various embodiments", "other embodiments", "alternative embodiment", and the like are intended to mean that any such features are included in one or more embodiments of the present disclosure, but may or may not necessarily be combined in the same embodiments.

It is also important to note that the functions related to downsampling using averaging over N samples illustrate only some of the possible functions that may be executed by, or within, systems illustrated in FIGURES 5 and 6. Some of these operations may be deleted or removed where appropriate, or these operations may be modified or changed considerably without departing from the scope of the present disclosure. In addition, the timing of these operations may be altered considerably. The preceding operational flows have been offered for purposes of example and discussion. Substantial flexibility is provided by embodiments described herein in that any suitable arrangements, chronologies, configurations, and timing mechanisms may be provided without departing from the teachings of the present disclosure.

Numerous other changes, substitutions, variations, alterations, and modifications may be ascertained to one skilled in the art and it is intended that the present disclosure encompass all such changes, substitutions, variations, alterations, and modifications as falling within the scope of the appended claims. In order to assist the United States Patent and Trademark Office (USPTO) and, additionally, any readers of any patent issued on this application in interpreting the claims appended hereto, Applicant wishes to note that the Applicant: (a) does not intend any of the appended claims to invoke paragraph six (6) of 35 U.S.C. section 112 as it exists on the date of the filing hereof unless the words "means for" or "step for" are specifically used in the particular claims; and (b) does not intend, by any statement in the specification, to limit this disclosure in any way that is not otherwise reflected in the appended claims.

Note that all optional features of the apparatus described above may also be implemented with respect to the method or process described herein and specifics in the examples may be used anywhere in one or more embodiments.

**Claims**

1. A method for computationally downsampling digital samples $x_n$, $x_{n+1}$, ... of a signal by a decimation factor d comprising an integer part i using averaging, the method comprising:

   based on the decimation factor d and a number N of samples to use for the averaging, identifying a partial sum to use for the downsampling, wherein the partial sum is identified as a sum $S_{n+i,n+N-1}$ of (N-i) samples $x_{n+i}$, ... $x_{n+N-1}$;
   computing the partial sum $S_{n+i,n+N-1}$;
   computing a first sum $S_{n,n+N-1}$ of a first set of N digital samples $x_n$, ... $x_{n+N-1}$ as a sum of a set of i digital samples $x_n$, ... $x_{n+i-1}$ and the computed partial sum $S_{n+i,n+N-1}$;
   computing a second sum $S_{n+i,n+i+N-1}$ of a second set of N digital samples $x_{n+i}$, ... $x_{n+i+N-1}$ as a sum of a set of i digital samples $x_{n+N}$, ... $x_{n+i+N-1}$ and the computed partial sum $S_{n+i,n+N-1}$; and
   downsampling the digital samples based at least in part on the first sum $S_{n,n+N-1}$ and the second sum $S_{n+i,n+i+N-1}$.

2. The method according to claim 1, further comprising selecting the number N based on the decimation factor d by selecting N to be an integer that is equal to or greater than d+2 and less than 2i.

3. The method according to claims 1 or 2, further comprising computing a first additional sum $S_{n+1,n+N}$ by subtracting $x_n$ from the first sum $S_{n,n+N-1}$ and by adding another digital sample $x_{n+N}$.

4. The method according to claim 3, further comprising computing a second additional sum $S_{n+i+1,n+i+N}$ by subtracting $x_{n+i}$ from the second sum $S_{n+i,n+i+N-1}$ and by adding another digital sample $x_{n+i+N}$.

5. The method according to claim 4, wherein the downsampling of the digital samples based at least in part on the first sum $S_{n,n+N-1}$ and the second sum $S_{n+i,n+i+N-1}$ comprises computing a first output digital sample $y_n$ by interpolating between the first sum $S_{n,n,N-1}$ and the first additional sum $S_{n+1,n+N}$, and computing a second output digital sample $y_{n+1}$ by interpolating between the second sum $S_{n-i,n-i+N-1}$ and the second additional sum $S_{n+i+1,n+i+N}$.

6. The method according to claim 5, wherein:

   the interpolating between the first sum $S_{n,n+N-1}$ and the first additional sum $S_{n+1,n+N}$ comprises computing the first output digital sample $y_n$ as a weighted average, over the number N of samples, between the first sum $S_{n,n+N-1}$ and the first additional sum $S_{n+1,n+N}$ as $y_n = \frac{1}{N}((S_{n,n+N-1}) + 0 * S_{n+1,n+N})$, and

   the interpolating between the second sum $S_{n+i,n+i+N-1}$ and the second additional sum $S_{n+i+1,n+i+N}$ comprises computing the second output digital sample $y_{n+1}$ as a weighted average, over the number N of samples, between the second sum $S_{n+i,n+i+N-1}$ and the second additional sum $S_{n+i+1,n+i+N}$ as

   $$y_{n+1} = \frac{1}{N}((1-f) \times S_{n+i,n+i+N-1} + f \times S_{n+i+1,n+i+N}),$$

   where f is a fractional part of the decimation factor d.

7. The method according to any preceding claim, wherein N is 16 and the digital samples are downsampled by the decimation factor of 10.3.

8. The method according to any preceding claim, wherein the digital samples correspond to a two-dimensional signal.

9. The method according to claim 8, wherein the two-dimensional signal corresponds to raster-scan image data, and wherein the method further comprises storing partial sums corresponding to a row of input data.

10. A system for computationally downsampling digital samples $x_n$, $x_{n+1}$, ... of a signal by a decimation factor d comprising an integer part i using averaging, the system comprising:

at least one memory configured to store computer executable instructions; and

at least one processor coupled to the at least one memory and configured, upon executing the instructions, to:

based on the decimation factor d and a number N of samples to use for the averaging, identify a partial sum to use for the downsampling, wherein the partial sum is identified as a sum $S_{n+i,n+N-1}$ of (N-i) samples $x_{n+i}$, ... $x_{n+N-1}$;

compute the partial sum $S_{n+i,n+N-1}$;

compute a first sum $S_{n,n+N-1}$ of a first set of N digital samples $x_n$, ... $x_{n+N-1}$ as a sum of a set of i digital samples $x_n$, ... $x_{n+i-1}$ and the computed partial sum $S_{n+i,n+N-1}$;

compute a second sum $S_{n+i,n+i+N-1}$ of a second set of N digital samples $x_{n+i}$, ... $x_{n+i+N-1}$ as a sum of a set of i digital samples $x_{n+N}$, ... $x_{n+i+N-1}$ and the computed partial sum $S_{n+i,n+i+N-1}$; and

downsample the digital samples based at least in part on the first sum $S_{n,n+N-1}$ and the second sum $S_{n+i,n+i+N-1}$.

11. The system according to claim 10, wherein the at least one processor is further configured to select the number N based on the decimation factor d by selecting N to be an integer that is equal to or greater than d+2 and less than 2i.

12. The system according to claims 10 or 11, wherein the at least one processor is further configured to compute a first additional sum $S_{n+1,n+N}$ by subtracting $x_n$ from the first sum $S_{n,n+N-1}$ and by adding another digital sample $x_{n+N}$ and compute a second additional sum $S_{n+i+1,n+i+N}$ by subtracting $x_{n+i}$ from the second sum $S_{n+i,n+i+N-1}$ and by adding another digital sample $x_{n+i+N}$.

13. The system according to claim 12, wherein the downsampling of the digital samples based at least in part on the first sum $S_{n,n+N-1}$ and the second sum $S_{n+i,n+i+N-1}$ comprises the at least one processor computing a first output digital sample $y_n$ by interpolating between the first sum $S_{n,n+N-1}$ and the first additional sum $S_{n+1,n+N}$, and computing a second output digital sample $y_{n+1}$ by interpolating between the second sum $S_{n+i,n+i+N-1}$ and the second additional sum $S_{n+i+1,n+i+N}$.

14. The system according to claim 13, wherein:

the interpolating between the first sum $S_{n,n+N-1}$ and the first additional sum $S_{n+1,n+N}$ comprises computing the first output digital sample $y_n$ as a weighted average, over the number N of samples, between the first sum $S_{n,n+N-1}$ and the first additional sum $S_{n+1,n+N}$ as $y_n = \frac{1}{N}((S_{n,n+N-1}) + 0 * S_{n+1,n+N})$, and

the interpolating between the second sum $S_{n+i,n+i+N-1}$ and the second additional sum $S_{n+i+1,n+i+N}$ comprises computing the second output digital sample $y_{n+1}$ as a weighted average, over the number N of samples, between the second sum $S_{n+i,n+i+N-1}$ and the second additional sum $S_{n+i+1,n+i+N}$ as

$$y_{n+1} = \frac{1}{N}((1-f) \times S_{n+i,n+i+N-1} + f \times S_{n+i+1,n+i+N}),$$

where f is a fractional part of the decimation factor d.

15. A non-transitory computer readable storage medium storing software code portions configured for, when executed on a processor, carrying out a method for computationally downsampling digital samples $x_n$, $x_{n+1}$, ... of a signal by a decimation factor d comprising an integer part i using averaging, the method comprising:

based on the decimation factor d and a number N of samples to use for the averaging, identifying a partial sum to use for the downsampling, wherein the partial sum is identified as a sum $S_{n+i,n+N-1}$ of (N-i) samples $x_{n+i}$, ... $x_{n+N-1}$;

computing the partial sum $S_{n+i,n+N-1}$;

computing a first sum $S_{n,n+N-1}$ of a first set of N digital samples $x_n$, ... $x_{n+N-1}$ as a sum of a set of i digital samples $x_n$, ... $x_{n+i-1}$ and the computed partial sum $S_{n+i,n+N-1}$;

computing a second sum $S_{n+i,n+i+N-1}$ of a second set of N digital samples $x_{n+i}$, ... $x_{n+i+N-1}$ as a sum of a set of i digital samples $x_{n+N,}$ ... $x_{n+i+N-1}$ and the computed partial sum $S_{n+i,n+N-1}$; and

downsampling the digital samples based at least in part on the first sum $S_{n,n+N-1}$ and the second sum $S_{n+i,n+i+N-1}$.

100

```
┌─────────────────────────────────┐
│   Select N based on the decimation │ ⟋ 102
│            factor d                │
└─────────────────────────────────┘
                 │
                 ▼
┌─────────────────────────────────┐
│  Identify a first partial sum to use for │ ⟋ 104
│            downsampling            │
└─────────────────────────────────┘
                 │
                 ▼
┌─────────────────────────────────┐
│  Compute the first partial sum and  │ ⟋ 106
│     store in a hardware register    │
└─────────────────────────────────┘
                 │
                 ▼
┌─────────────────────────────────┐
│    Compute a first sum and a second │ ⟋ 108
│     sum using the first partial sum  │
└─────────────────────────────────┘
                 │
                 ▼
┌─────────────────────────────────┐
│  Downsample digital samples using the │ ⟋ 110
│        first and second sums        │
└─────────────────────────────────┘
```

FIGURE 1A

100

```
┌─────────────────────────────────┐
│   Compute a third sum using the first   │──── 112
│              sum              │
└─────────────────────────────────┘
                 │
                 ▼
┌─────────────────────────────────┐
│    Compute a fourth sum using the    │──── 114
│           second sum           │
└─────────────────────────────────┘
                 │
                 ▼
┌─────────────────────────────────┐
│  Compute a first output digital sample  │
│ by interpolating between the first and  │──── 116
│             third sums            │
└─────────────────────────────────┘
                 │
                 ▼
┌─────────────────────────────────┐
│   Compute a second output digital    │
│  sample by interpolating between the   │──── 118
│        second and fourth sums        │
└─────────────────────────────────┘
```

FIGURE 1B

200

N-i

N

$x_{n+N-1}$   $x_{n+2i}$   $x_{n+i+N-1}$

202

| $x_n$ | $x_{n+1}$ | | | | | | | $x_{n+i}$ | | | | $x_{n+N}$ | | | | | | | | | | | |

204

$S_{n,n+N-1}$   $(S_{n+i,n+N-1})$

208

206   218

$(S_{n+i,n+N-1})$   $(S_{n+i,n+i+N-1})$   $(S_{n+2i,n+i+N-1})$

208

218   216

$(S_{n+2i,n+i+N-1})$   $(S_{n+2i,n+2i+N-1})$

220

210   212   214

FIGURE 2

16

FIGURE 3

400

| $x_0$ | $x_1$ | $x_2$ | $x_3$ | $x_4$ | $x_5$ | $x_6$ | $x_7$ | $x_8$ | $x_9$ | $x_{10}$ | $x_{11}$ | $x_{12}$ | $x_{13}$ | $x_{14}$ | $x_{15}$ | $x_{16}$ | $x_{17}$ | $x_{18}$ | $x_{19}$ | $x_{20}$ | $x_{21}$ | $x_{22}$ | $x_{23}$ | $x_{24}$ | $x_{25}$ | $x_{26}$ | $x_{27}$ | $x_{28}$ | $x_{29}$ |

$S_{0,15}$ $(S_{10,15})$

$S_{1,16}$

$(S_{10,15})$ $S_{10,25}$ $(S_{20,25})$

$S_{11,26}$

$(S_{20,25})$ $S_{20,35}$

$S_{21,36}$

FIGURE 4

500

502

504

508

506

510

Averaging Filter

Interpolator

Stored
Sample(s)

Stored Partial
Sum(s)

512

510

FIGURE 5

FIGURE 6

Europäisches
Patentamt

European
Patent Office

Office européen
des brevets

## EUROPEAN SEARCH REPORT

**Application Number**

EP 16 15 6808

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 672 626 A2 (ANALOG DEVICES INC [US]) 11 December 2013 (2013-12-11) * the whole document * | 1-15 | INV. G06F17/18 |

TECHNICAL FIELDS
SEARCHED     (IPC)

G06F

The present search report has been drawn up for all claims

| Place of search | Date of completion of the search | Examiner |
|---|---|---|
| Berlin | 7 July 2016 | Virnik, Elena |

EPO FORM 1503 03.82 (P04C01)

## ANNEX TO THE EUROPEAN SEARCH REPORT
## ON EUROPEAN PATENT APPLICATION NO.

EP 16 15 6808

This annex lists the patent family members relating to the patent documents cited in the above-mentioned European search report.
The members are as contained in the European Patent Office EDP file on
The European Patent Office is in no way liable for these particulars which are merely given for the purpose of information.

07-07-2016

| Patent document cited in search report | | Publication date | Patent family member(s) | | Publication date |
|---|---|---|---|---|---|
| EP 2672626 | A2 | 11-12-2013 | CN | 103546120 A | 29-01-2014 |
| | | | EP | 2672626 A2 | 11-12-2013 |
| | | | KR | 20130137091 A | 16-12-2013 |
| | | | US | 2013332495 A1 | 12-12-2013 |

EPO FORM P0459

For more details about this annex : see Official Journal of the European Patent Office, No. 12/82